# DEMANDE DE BREVET EUROPEEN

(11) **EP 4 303 595 A1**
(43) Date de publication de la demande: **10.01.2024**
(21) Numéro de dépôt: 23183201.5
(22) Date de dépôt: 04.07.2023
(51) Int. Cl.: G01R 22/06

(54) **DISPOSITIF DE COMPTEUR D'ENERGIE ELECTRIQUE POUR BORNE DE RECHARGE EN ENERGIE ELECTRIQUE D'UNITES MOBILES TELLES QUE DES VEHICULES ELECTRIQUES ET UNE TELLE BORNE DE RECHARGE COMPRENANT UN TEL DISPOSITIF**

(30) Priorité: 04.07.2022 FR 2206758
(71) Demandeur: HAGER CONTROLS, 67700 Saverne (FR)
(72) Inventeur: CASTELOT, Geoffrey, 67270 WILWISHEIM (FR); GARTISER, Alain, 57400 SARREBOURG (FR); MONIOT, Frédéric, 67200 STRASBOURG (FR); STURTZER, Eric, 67500 HAGUENAU (FR)
(74) Mandataire: Cabinet Nuss

(57) **Abrégé**

La présente invention a pour objet un dispositif de compteur d'énergie électrique pour borne de recharge (B) en énergie électrique d'unités mobiles telles que des véhicules électriques, une telle borne de recharge (8) comprenant au moins un point de recharge (B1), ledit dispositif comprenant au moins un compteur d'énergie électrique (1) apte et destiné à être fixé dans une telle borne de recharge (B) en étant dédié au ou à l'un de ses point(s) de recharge (B1) et à mesurer, avec une précision de mesure conforme, la quantité d'énergie électrique transmise par ledit point de recharge (B1) à l'unité mobile lors de sa recharge et au moins un élément d'affichage électronique (4).

Un tel dispositif comprend en outre au moins un module (2) d'authentification permettant de contrôler l'authenticité desdites mesures et au moins une liaison de communication série reliant fonctionnellement ledit module d'authentification au ou à au moins l'un desdits compteur(s) d'énergie électrique (1) et des moyens de fixation permettant de fixer le ou chaque module (2) d'authentification dans la borne de recharge (B) concernée. Elle a également pour objet une telle borne de recharge comprenant un tel dispositif.

## Description

[La présente invention concerne le domaine de la distribution d'énergie électrique pour la recharge en énergie électrique des unités mobiles telles que des véhicules électriques et a pour objet un dispositif de compteur d'énergie électrique pour borne de recharge en énergie électrique d'unités mobiles telles que des véhicules électriques. Elle a également pour objet une telle borne de recharge comprenant un tel dispositif.

La distribution de l'énergie électrique pour la recharge des véhicules électriques est assurée par des bornes de recharge en énergie électrique disposées de manière fixe sur des sites privés ou publics généralement externes et dans des environnements divers. Ces bornes sont prévues pour pouvoir être connectées à au moins un véhicule électrique et sont généralement alimentées par un réseau de distribution électrique.

Ces bornes de recharge sont également connues sous le nom de stations ou colonnes de recharge. Il est également connu des stations de recharge comprenant plusieurs bornes de recharge.

Une telle borne de recharge comprend au moins un point de recharge généralement matérialisé(e) par une prise électrique (socle de prise électrique) ou par un câble de recharge connecté à ladite borne, un contrôleur de charge permettant de contrôler l'énergie électrique transmise au véhicule électrique connecté à ladite borne et des connexions et câbles électriques pour l'alimentation en courant et la distribution électrique via la ou les prises ou le ou les câbles. Le ou chaque point de recharge permet la recharge d'un véhicule électrique. Une telle borne de recharge comprend généralement un ou deux points de recharge.

D'autre part, afin de pouvoir connaître la quantité d'énergie électrique délivrée par les bornes de recharge aux véhicules électriques lors de leur recharge, les bornes de recharges comprennent au moins un compteur d'énergie électrique dédié au ou à l'un des points de recharge et permettant de mesurer ladite quantité d'énergie électrique consommée à la borne au niveau dudit point de recharge dédié.

Par ailleurs, l'utilisation de tels compteurs d'énergie électrique n'est autorisée pour la facturation de l'énergie électrique distribuée par la borne de recharge que dans le cas où ces compteurs sont conformes aux règlementations, directives ou lois en la matière, plus particulièrement à la directive/norme européenne 2014/32/UE, plus communément connue sous le nom de directive/norme MID (Measurement Instrument Directive).

Les compteurs d'énergie électrique autorisés par cette directive européenne MID sont connus sous le nom de compteurs d'énergie électrique certifiés MID et permettent de réaliser des mesures de la quantité d'énergie électrique distribuée ou consommée de façon précise. Cette précision des valeurs mesurées est exigée pour permettre la facturation de sorte que les compteurs d'énergie électrique qui ne sont pas conformes à cette directive européenne MID ne peuvent pas être utilisés pour la facturation mais uniquement pour donner des indications à l'utilisateur sur les mesures effectuées.

La directive européenne MID impose également que ces compteurs d'énergie électrique intègrent un afficheur électronique. Cet afficheur électronique est intégré dans le compteur d'énergie électrique de sorte à être visible depuis l'extérieur du compteur et se présente généralement sous la forme d'un écran numérique. Un compteur d'énergie électrique certifié MID est monté dans une borne de recharge de sorte que l'afficheur électronique soit également visible par un utilisateur depuis l'extérieur de la borne de recharge grâce à une fenêtre/ouverture pratiquée dans une paroi externe de ladite borne délimitant son espace intérieur et située en regard de l'afficheur électronique ou recevant ce dernier.

Ces compteurs d'énergie électrique certifiés MID équipant les bornes de recharge de véhicules électriques sont commercialisés, par exemple, sous la référence ECR380D, par la présente demanderesse et, par exemple, sous la référence M3PRO 80 Modbus MID, par la société Herloldt Controls.

Toutefois si ces compteurs d'énergie électrique certifiés MID permettent de réaliser une mesure de comptage de la quantité d'énergie électrique distribuée avec la précision demandée par la directive européenne MID, ils ne permettent pas de garantir que cette mesure est exacte, c'est-à-dire qu'elle n'a pas fait l'objet de corruption/fraude intentionnelle ou accidentelle. Or, cette garantie de l'authentification (ou l'intégrité) des mesures permettant de protéger les consommateurs d'électricité est exigée pour la facturation, par exemple, par la loi allemande sur la mesure et l'étalonnage (« Eichrecht »), en plus de la précision de la mesure exigée par la directive européenne MID.

Pour répondre à cette exigence supplémentaire, notamment de la loi allemande, il a été développé des compteurs d'énergie électrique certifiés MID avec contrôle de l'authentification des mesures, connus actuellement sous le nom de compteur d'énergie électrique eHZ (abrégé de l'expression allemande Elektronische Haushaltszähler). Un tel compteur d'énergie électrique eHZ intègre dans un boitier les fonctionnalités d'un compteur d'énergie électrique standard certifié MID et un circuit électronique d'authentification des mesures réalisant leur authentification par un mécanisme électronique de signature desdites mesures à partir de clés de sécurité mémorisées et d'un programme/logiciel d'authentification spécifique. Plus particulièrement, une carte électronique du compteur d'énergie électrique eHZ gère à la fois les mesures et leur authentification. Ainsi, une fois que le programme/logiciel a effectué l'authentification des mesures, les consommateurs peuvent connaître de manière fiable la quantité d'énergie électrique consommée pendant leur session de charge et quel montant correspondant à cette quantité leur a été facturé.

Afin de permettre une application de ces compteurs d'énergie électrique dans le domaine de l'électro-mobilité (mobilité électrique), ceux-ci sont conçus de sorte à pouvoir réaliser des mesures en les restituant en watt-heure (Wh). Afin de permettre une application de ces compteurs d'énergie électrique dans le domaine de l'électro-mobilité (mobilité électrique), ceux-ci sont conçus de sorte à respecter la section du cahier des charges (par exemple connu sous le nom allemand « Lastenheft ») dédié à l'électromobilité ; permettant, par exemple, de réaliser et restituer des mesures en watt-heure (Wh).

Deux types de compteurs d'énergie électrique standards sont ainsi commercialisés actuellement, les compteurs d'énergie électrique standards certifiés MID qui ne sont pas conformes, par exemple, à la loi allemande sur la mesure et l'étalonnage et les compteurs d'énergie électrique standards eHZ qui sont conformes à la directive MID et, par exemple, à ladite loi allemande.

Toutefois, ces compteurs d'énergie électrique standards eHZ posent plusieurs problèmes pour leur installation dans une borne de recharge. Tout d'abord, un problème de fixation et de coût car un tel compteur d'énergie électrique standard eHZ doit comprendre un boîtier adapté, avec un support de fixation spécifique, pour permettre sa fixation dans une borne de recharge, contrairement à un compteur d'énergie électrique standard certifié MID qui peut être installé facilement dans une borne de recharge en étant clipsé simplement sur un rail DIN prémonté dans cette dernière. D'autre part, un problème d'encombrement, car un compteur d'énergie électrique standard eHZ est plus volumineux ou encombrant qu'un compteur d'énergie électrique standard certifié MID et une borne de recharge nécessite autant de compteurs d'énergie électrique que de points de recharge. Ainsi, pour une borne de recharge utilisant de manière classique au moins deux points de recharge, celle-ci nécessite au moins deux compteurs électrique standard eHZ et leur support de fixation spécifique. En outre, les dimensions d'un tel compteur de ce type, et notamment de la face du boîtier comportant l'afficheur numérique, ne permettent pas sa disposition sur un petit côté de la borne où peuvent être situés les points de recharge.

La présente invention a pour but de pallier ces inconvénients.

A cet effet, la présente invention a pour objet un dispositif de compteur d'énergie électrique pour borne de recharge en énergie électrique d'unités mobiles telles que des véhicules électriques, une telle borne de recharge comprenant au moins un point de recharge permettant de distribuer de l'énergie électrique à une unité mobile connectée fonctionnellement audit point de recharge, ledit dispositif comprenant au moins un compteur d'énergie électrique apte et destiné à être fixé dans une telle borne de recharge en étant dédié au ou à l'un de ses point(s) de recharge et à mesurer, avec une précision de mesure conforme, la quantité d'énergie électrique transmise par ledit point de recharge à l'unité mobile lors de sa recharge et au moins un élément d'affichage électronique, se caractérisant essentiellement en ce qu'il comprend en outre au moins un module d'authentification des mesures comprenant un circuit électronique d'authentification configuré pour pouvoir contrôler l'authenticité des mesures, au moins une liaison de communication série reliant fonctionnellement ledit module d'authentification au ou à au moins l'un desdits compteur(s) d'énergie électrique de sorte que ce dernier puisse transmettre les mesures audit module d'authentification en vue de leur authentification et des moyens de fixation permettant de fixer le ou chaque module d'authentification dans la borne de recharge concernée.

La présente invention a également pour objet une borne de recharge en énergie électrique d'unités mobiles telles que des véhicules électriques, ladite borne de recharge comprenant au moins un point de recharge permettant de distribuer de l'énergie électrique à une unité mobile connectée fonctionnellement audit point de recharge, se caractérisant essentiellement en ce qu'elle comprend en outre un dispositif de compteur d'énergie électrique selon la présente invention et en ce que le ou chaque compteur d'énergie électrique et le ou chaque module d'authentification est fixé dans l'espace interne de la borne de recharge.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
[Fig. 1] est une vue en perspective d'une borne de recharge, selon la présente invention, avec un unique point de recharge, ladite vue montrant l'espace intérieur de ladite borne occupé par un dispositif de compteur d'énergie électrique selon la présente invention, dans un mode de réalisation dudit dispositif comprenant un unique compteur d'énergie électrique dédié audit point de recharge et un unique module d'authentification avec écran d'affichage électronique,
[Fig. 2] montre la borne de recharge représentée sur la figure 1 selon un angle de vue différent montrant le point de recharge,

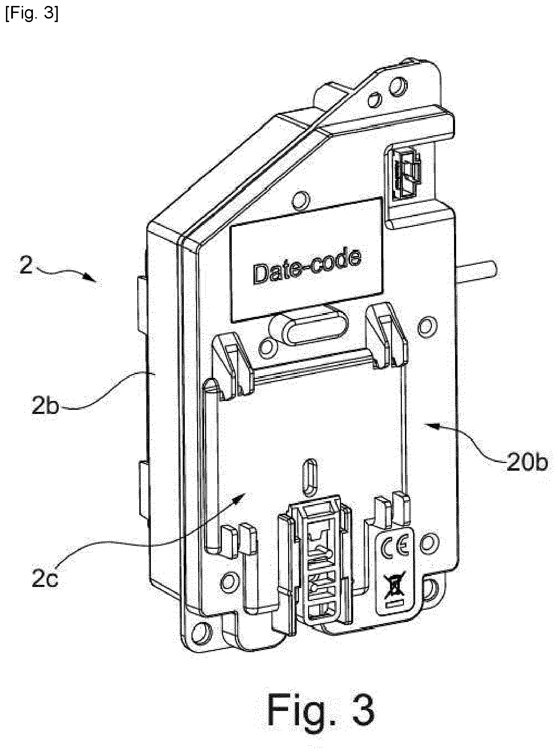

[Fig. 3] est une vue en perspective du module d'authentification de la borne de recharge représentée sur la figure 1, côté face de fixation dudit module,
[Fig. 4] montre le module d'authentification représenté sur la figure 3, côté face opposée à la face de fixation, ladite face opposée formant une face d'affichage,
[Fig. 5] est une vue en perspective du dispositif de compteur d'énergie électrique représenté sur la figure 1, avec une représentation schématique de la liaison de communication série reliant fonctionnellement ledit compteur d'énergie électrique et le module d'authentification,
[Fig. 6] est une vue en perspective d'un dispositif de compteur d'énergie électrique, selon la présente invention, dans un autre mode de réalisation comprenant deux compteurs d'énergie électrique et un unique module d'authentification relié fonctionnellement à ces derniers,
[Fig. 7] est un schéma bloc d'un dispositif de compteur d'énergie électrique, selon la présente invention, comprenant une pluralité de compteurs d'énergie électrique et un unique module d'authentification relié fonctionnellement à ces derniers,
[Fig. 8] est un schéma bloc du dispositif de compteur d'énergie électrique représenté sur la figure 1.

Sur les figures annexées on peut voir un dispositif de compteur d'énergie électrique pour borne de recharge en énergie électrique d'unités mobiles telles que des véhicules électriques, ainsi qu'une telle borne de recharge équipée dudit dispositif.

La borne de recharge B comprend au moins un point de recharge B1 permettant de distribuer de l'énergie électrique à une unité mobile fonctionnellement connectée audit point de recharge B1. Une telle borne de recharge B est également connue, par exemple, sous le nom de station ou colonne de recharge.

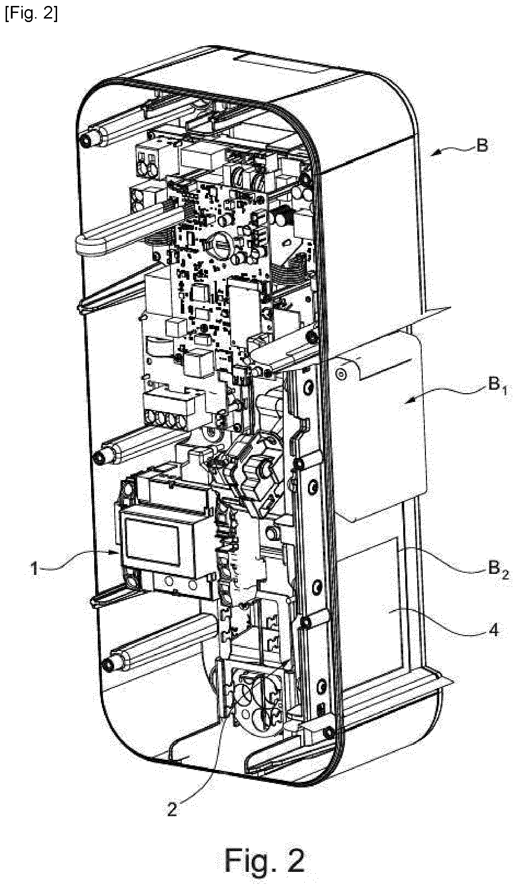

Un point de recharge B1 peut être une prise électrique (socle de prise électrique), éventuellement munie d'un volet de fermeture (voir figure 2 montrant une telle prise ou socle de prise électrique avec volet de fermeture) ou la prise connectée à l'extrémité d'un câble de recharge connecté à ladite borne (cas non représenté sur les figures annexées).

Le dispositif de compteur d'énergie électrique, selon la présente invention, comprend au moins un compteur d'énergie électrique 1 apte et destiné à être fixé dans une telle borne de recharge B en étant dédié au ou à l'un de ses point(s) de recharge B1 et à mesurer, avec une précision de mesure conforme, la quantité d'énergie électrique transmise par ledit point de recharge B1 à l'unité mobile lors de sa recharge et au moins un élément d'affichage électronique.

On entend par précision de mesure conforme, une précision de mesure conforme à la loi, règlementation ou directive applicable sur les instruments de mesure tels que les compteurs d'énergie électrique, par exemple la directive/norme européenne 2014/32/UE plus communément connue sous le nom de directive/norme MID (Measurement Instrument Directive).

On comprend que le ou chaque compteur d'énergie électrique 1 du dispositif selon la présente invention est un compteur d'énergie électrique 1 standard, par exemple un compteur d'énergie électrique standard certifié MID ou respectant une telle certification MID, ou une autre certification analogue. Un tel compteur d'énergie électrique 1 standard certifié MID est à distinguer d'un compteur d'énergie électrique standard, eHZ ou respectant une telle certification eHZ ou une autre certification analogue, intégrant en outre (en plus de la fonction de mesure avec précision conformément à la directive MID ou certification analogue) une fonction d'authentification, par exemple conforme à la loi ou norme allemande de mesure et d'étalonnage précitée (« Eichrecht »). Un tel compteur d'énergie électrique standard eHZ utilisé pour équiper une telle borne de recharge B présente les inconvénients mentionnés dans la première partie de la présente demande.

De préférence, le compteur d'énergie électrique 1 du dispositif selon la présente invention est conçu pour réaliser des mesures en les restituant en Wh (watt-heure) afin de permettre une application dans le domaine de l'électromobilité qui demande de telles mesures et restitutions en Wh. Les watts heure correspondent à/mesurent la quantité d'énergie consommée sur une période donnée.

Le ou chaque compteur d'énergie électrique 1 du dispositif selon la présente invention peut être, par exemple, un compteur d'énergie électrique 1 du commerce, par exemple commercialisé, sous la référence M3PRO 80 Modbus MID, par la société Herloldt Controls.

Le compteur d'énergie électrique 1 du dispositif selon la présente invention peut comprendre un boîtier 1a renfermant l'ensemble des circuits de mesure réalisant les mesures avec la précision conforme, plus particulièrement à la directive MID, et les moyens de fixation permettant la fixation du boîtier sur un support, par exemple sur un rail DIN, prémonté dans une borne de recharge B. Il peut comprendre en outre, comme c'est le cas généralement pour ce type de compteur électrique, un moyen d'affichage électronique 4, du type écran ou afficheur numérique, apparent sur la face avant du boîtier à travers une fenêtre ou ouverture pratiquée dans ce dernier. La présente invention peut prévoir qu'un tel moyen d'affichage 4, notamment dans le cas où le ou au moins l'un des modules 2 d'authentification décrit(s) par la suite comprend un moyen d'affichage 4, ne soit pas utilisé, c'est-à-dire qu'il ne soit pas, de préférence, rendu apparent ou visible depuis l'extérieur de la borne de recharge B dans laquelle est installé le dispositif selon la présente invention.

Conformément à la présente invention, un tel dispositif de compteur d'énergie électrique comprend en outre :
- au moins un module 2 d'authentification des mesures comprenant un circuit électronique d'authentification 2a configuré pour pouvoir contrôler l'authenticité desdites mesures, c'est-à-dire de chaque mesure réalisée par le ou au moins l'un des compteurs d'énergie électrique 1,
- au moins une liaison de communication série 3 reliant fonctionnellement ledit module 2 d'authentification au ou à au moins l'un desdits compteur(s) d'énergie électrique 1 de sorte que ce dernier puisse transmettre les mesures audit module 2 d'authentification en vue de leur authentification,
- et des moyens de fixation 2c permettant de fixer le ou chaque module 2 d'authentification dans la borne de recharge B concernée.

Une telle liaison série 3 confère plusieurs avantages au dispositif de compteur d'énergie électrique selon la présente invention. Elle est notamment d'un prix de revient faible, tout en étant particulièrement adaptée pour les mesures/données transmises par le(s) compteur(s) d'énergie électrique 1 au module 2 d'authentification qui constituent des petites trames de données ne nécessitant pas de grandes vitesses de transmission. Elle est d'autre part particulièrement adaptée pour obtenir ou renforcer la protection CEM (compatibilité électromagnétique) du module 2 d'authentification auquel elle est reliée et donc pour obtenir une plus grande fiabilité de l'authenticité des mesures.

L'authenticité (ou l'intégrité) des mesures signifie que les mesures sont garanties, après leur contrôle (ou vérification) par le module 2 d'authentification comme étant exactes, c'est-à-dire que lesdites mesures n'ont pas été modifiées, par fraude ou corruption par exemple, depuis qu'elles ont été générées ou réalisées par le compteur d'énergie électronique 1 relié audit module 2 d'authentification.

De préférence, le circuit électronique d'authentification 2 est configuré pour authentifier les mesures en les contrôlant de sorte à pouvoir les authentifier en signant les mesures authentifiées à l'aide de clés de sécurités mémorisées et en mémorisant lesdites mesures authentifiées et signées.

On comprend que le ou chaque compteur d'énergie électrique 1 du dispositif selon la présente invention, qui intègre ou assure la fonction de mesure avec précision, n'intègre pas ou n'assure pas la fonction d'authentification desdites mesures, cette dernière fonction étant intégrée dans le ou assurée par le au moins un module 2 d'authentification des mesures relié fonctionnellement au(x) compteur(s) d'énergie électrique 1 du dispositif selon la présente invention.

Une borne de recharge B prévue pour recevoir un dispositif selon la présente invention peut comprendre un contrôleur de charge contrôlant l'énergie électrique transmise à l'unité mobile connectée à ladite borne B. Le ou chaque module 2 d'authentification peut alors, préférentiellement, être relié en outre audit contrôleur de charge au moyen d'une liaison de communication série qui peut être du même type que celle reliant entre eux le ou les module(s) d'authentification au(x) compteur(s) d'énergie électrique 1.

Le ou chaque élément d'affichage électronique 4 peut être, par exemple, un afficheur ou écran numérique.

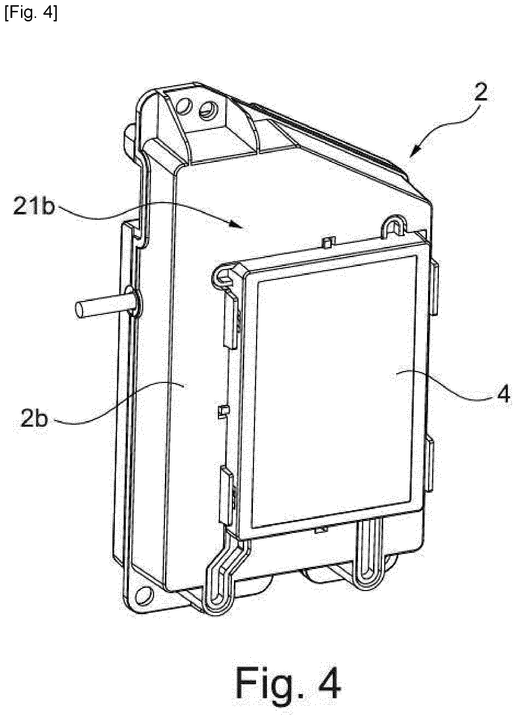

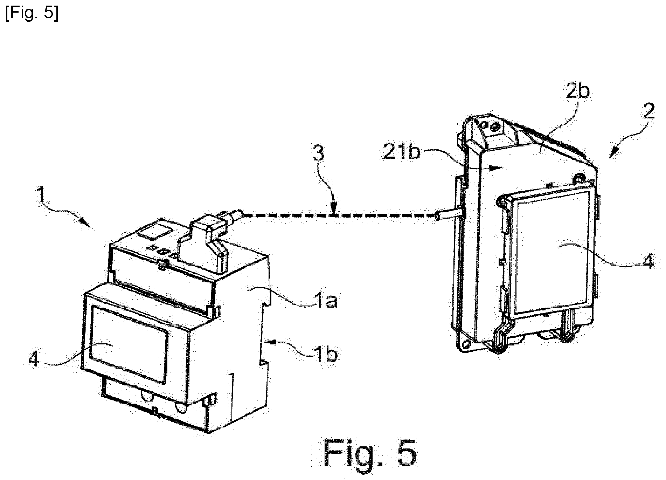

De préférence, comme on peut le voir sur les figures 2, 4, 5, 6 et 8, le ou au moins l'un des module(s) 2 d'authentification peut comprendre en outre le ou l'un des élément(s) d'affichage électronique 4 pour permettre l'affichage, au niveau du ou de chaque module 2 d'authentification concerné, d'informations provenant de son circuit électronique d'authentification 2a et/ou du ou de l'un des compteur(s) d'énergie électrique 1 relié(s) audit module 2 d'authentification. On comprend que l'élément d'affichage électronique 4 du ou de chaque module 2 d'authentification est relié au circuit électronique d'authentification 2a dudit module 2 d'authentification. Dans le cas où les informations proviennent du ou de l'un des compteur(s) d'énergie électrique 1 relié(s) audit module 2 d'authentification, celles-ci peuvent être transmises à l'élément d'affichage électronique 4 via le circuit électronique d'authentification 2a et sous son contrôle.

Comme on peut le voir sur les figures 2, 4, 5, 6, le ou chaque compteur d'énergie électrique 1 comprend (de manière classique) un boîtier 1a, dit premier boîtier 1a, délimitant son espace interne. Ce premier boîtier 1a comprend une face, formant de manière classique la face arrière du boîtier 1a, adaptée, par exemple, en comprenant une encoche de fixation 1b, pour permettre la fixation du boîtier 1a sur un support, par exemple sur un rail DIN (acronyme de « Deutsches Institut für Normung »), prémonté dans la borne de recharge B. Le ou chaque module 2 d'authentification comprend un boîtier 2b, dit deuxième boîtier 2b, renfermant le ou l'un des circuits électroniques d'authentification 2a. En outre, selon la présente invention, le ou chaque premier boîtier 1a est distinct du ou de chaque deuxième boîtier 2b, ce qui permet de dissocier la partie comptage/mesurage de la partie authentification des mesures et de prévoir un seul module 2 d'authentification pour gérer l'authentification des mesures provenant de plusieurs (au moins deux) compteurs d'énergie électrique 1, et ainsi d'obtenir un faible encombrement du dispositif dans la borne de recharge B. Les moyens de fixation 2c du ou de chaque module 2 d'authentification peuvent être intégrés dans leur boîtier 2b ou fixés sur ce dernier et peuvent consister en des vis ou en un montage ou une fixation sur un profilé support, par exemple un profilé support standardisé utilisé pour le support mécanique des appareils électriques, de préférence un tel profilé support standardisé du type rail DIN.

De préférence, le boîtier 2b du ou de chaque module 2 d'authentification présente deux faces 20b, 21b opposées, dont l'une desdites faces 20b forme une face 20b de fixation intégrant ou sur laquelle sont fixés les moyens de fixation 2c dudit module 2 d'authentification. Le cas échéant, lorsque le module 2 d'authentification comprend le ou l'un des moyens d'affichage électronique 4, l'autre face 21b opposée peut former une face 21b d'affichage. Selon le montage du moyen d'affichage électronique 4 dans le boîtier 2b, c'est-à-dire à l'intérieur du boîtier 2b ou à l'extérieur de ce dernier, la face 21b d'affichage peut, préférentiellement, soit comprendre une fenêtre/ouverture située en regard du ou recevant au moins une partie du moyen d'affichage électronique 4, soit former une face support sur laquelle est fixé le moyen d'affichage électronique 4.

Dans une forme de réalisation préférentielle, la liaison de communication série 3 est une liaison de communication série 3 du type respectant la norme RS485 ou un protocole de communication Modbus ou autre protocole présentant des fonctionnalités similaires. Dans ce cas, le boitier 2b du ou de chaque module 2 d'authentification peut comprendre au moins une ouverture de passage permettant le passage de la liaison de communication série 3 à travers ledit boîtier 2.

Dans une variante, la liaison de communication série 3 peut être une liaison de communication radiofréquence.

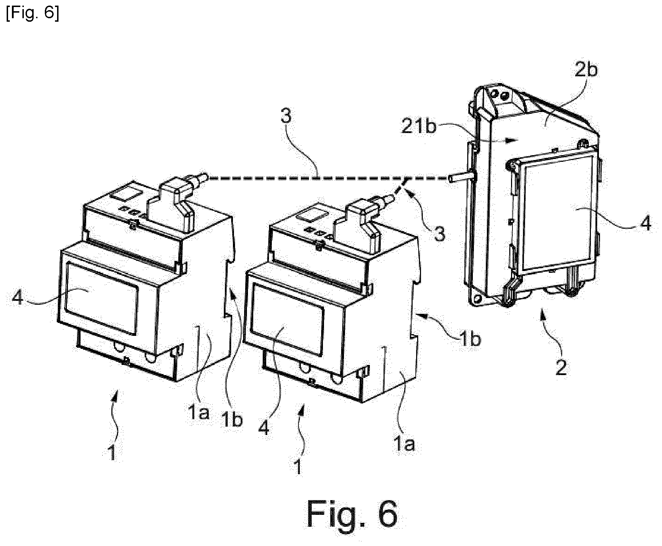

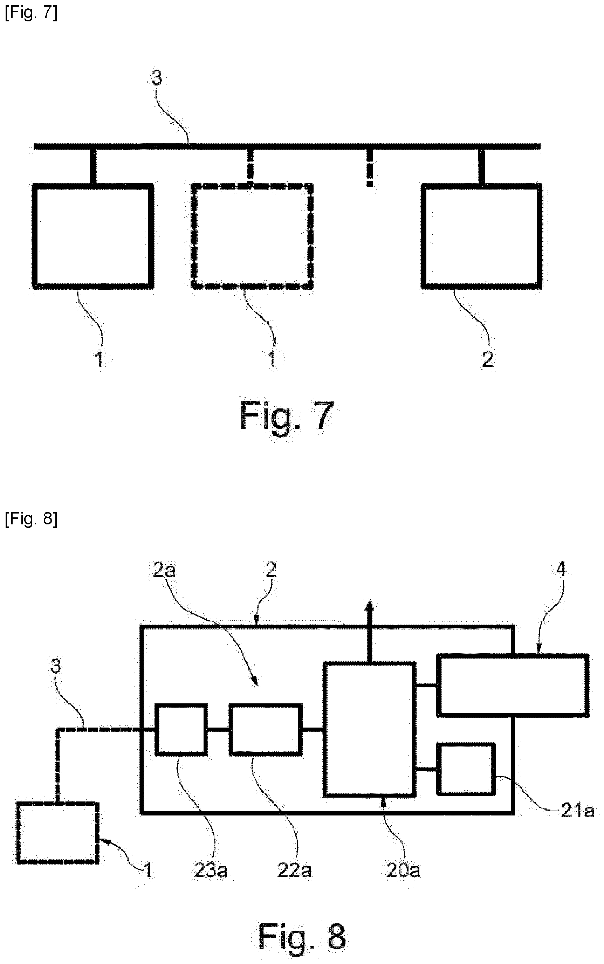

Dans un mode de réalisation préférentiel, lorsque le dispositif selon la présente invention est prévu pour équiper une borne de recharge B comprenant au moins deux points de recharge B1, le dispositif peut comprendre, comme on peut le voir sur les figures 6 et 7, d'une part, au moins deux compteurs d'énergie électrique 1 aptes et destinés à être dédiés chacun à l'un des points de recharge B1 de ladite borne de recharge B et, d'autre part, au moins un module 2 d'authentification. Le ou chaque module 2 d'authentification est alors relié auxdits compteurs d'énergie électrique 1 ou à au moins deux desdits compteurs d'énergie électrique 1 par la ou au moins l'une des liaison(s) de communication série 3, c'est à dire que le ou chaque module 2 d'authentification est relié à plusieurs compteurs d'énergie électrique 1.

Si on se réfère maintenant à la figure 8, on peut voir que, dans une forme de réalisation préférentielle, le circuit électronique d'authentification 2a du ou de chaque module 2 d'authentification peut comprendre une unité de traitement électronique telle qu'un microcontrôleur 20a, une mémoire 21a centrale et un circuit émetteur/récepteur 22a. La mémoire 21a centrale et le circuit émetteur/récepteur 22a sont reliés au microcontrôleur 20a. On peut voir également que le circuit électronique d'authentification 2a peut comprendre en outre, en entrée, un circuit de protection 23a CEM connectée en entrée en reliant le circuit émetteur/récepteur 22a à la liaison de communication série 3. Dans le cas où la liaison de communication série 3 est une liaison de communication série 3 du type RS485 ou Modbus, le circuit émetteur/récepteur 22a est un circuit émetteur/récepteur 22a informatique. Dans le cas où la liaison de communication série 3 est une liaison de communication série 3 radiofréquence, le circuit émetteur/récepteur 22a est un émetteur/récepteur 22a radio fréquence. La mémoire 21a centrale, qui peut être intégrée dans le microcontrôleur 20a, permet de stocker les mesures authentifiées et signées par le circuit électronique d'authentification 2a de sorte à garantir leur intégrité/authenticité. La combinaison de la liaison série et du circuit de protection 23a CEM permet de renforcer davantage la protection CEM du module 2 d'authentification .

Le ou chaque circuit électronique d'authentification 2a comprend à cet effet un programme/logiciel d'authentification des mesures exécuté par le microcontrôleur 20a pour authentifier et signer électroniquement lesdites mesures authentifiées à partir de clés de sécurité mémorisées. Le programme/logiciel et les clés de sécurités sont stockées de préférence dans la mémoire 21a centrale. L'accès aux clés d'authentification utilisées par le programme/ logiciel d'authentification est protégé de manière fiable pour que l'authenticité des mesures soit protégée de manière fiable.

Cette garantie de l'exactitude des mesures et donc de leur authenticité (ou intégrité) procurée par un tel dispositif de compteur d'énergie électrique selon la présente invention permet audit dispositif et à la borne de recharge B comprenant ou équipée de ce dernier d'être conforme, notamment pour être autorisé(e) pour la facturation, aux normes/directives/lois en vigueur de base telles que la directive européenne MID mais aussi aux normes/directives/lois en vigueur plus exigeantes telle que la loi allemande sur la mesure et l'étalonnage (l'Eichrecht), tout en offrant un dispositif de coût réduit et de faible encombrement dans la borne de recharge B.

La présente invention a également pour objet une borne de recharge B en énergie électrique d'unités mobiles telles que des véhicules électriques, ladite borne de recharge B comprenant au moins un point de recharge B1 permettant de distribuer de l'énergie électrique à une unité mobile connectée fonctionnellement audit point de recharge B1.

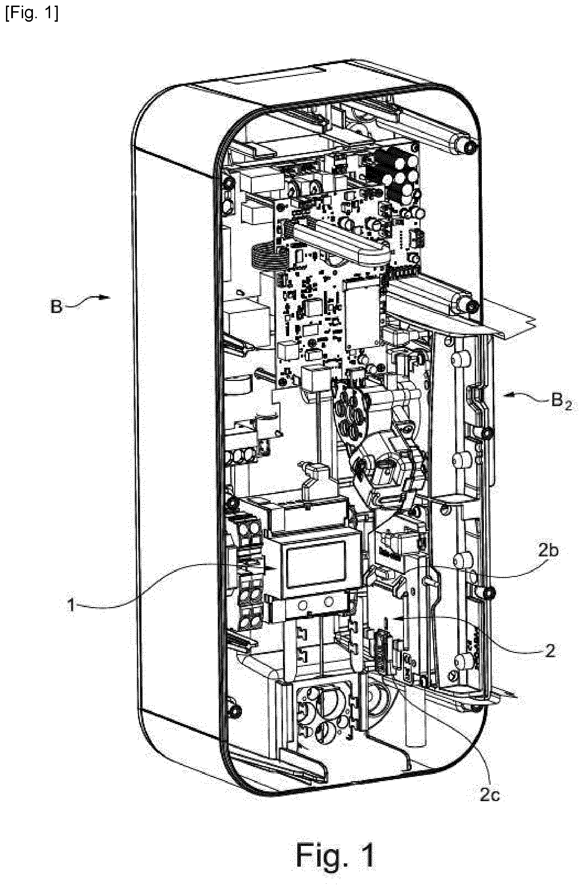

Conformément à la présente invention, comme on peut le voir sur les figures 1 et 2, une telle borne de recharge comprend en outre d'un dispositif de compteur d'énergie électrique selon la présente invention. Le ou chaque compteur d'énergie électrique 1 et le ou chaque module 2 d'authentification dudit dispositif de compteur d'énergie électrique sont fixés dans l'espace interne de la borne de recharge B.

Dans une forme de réalisation particulière, non représentée, une telle borne de recharge B comprend au moins deux points de recharge B1, au moins deux compteurs d'énergie électrique 1 dédiés chacun à l'un desdits points de recharge B1 et au moins un module 2 d'authentification, le ou chaque module 2 d'authentification étant relié auxdits compteurs d'énergie électrique 1 ou à au moins deux desdits compteurs d'énergie électrique 1.

Dans le cas ou le ou au moins l'un des module(s) 2 d'authentification comprend un élément d'affichage électronique 4, une telle borne de recharge B peut comprendre au moins une ouverture ou fenêtre B2 pratiquée à travers l'une de ses parois externes délimitant son espace interne et située en regard ou recevant l'élément d'affichage électronique 4 du ou de l'un des module 2 d'authentification de sorte à permettre à un utilisateur de voir ledit élément d'affichage électronique 4 depuis l'extérieur de la borne de recharge B (figures 1 et 2).

Dans une telle borne B, le ou chaque premier boîtier 1a est fixé dans la borne de recharge B en un point, dit premier point et le ou chaque deuxième boîtier 2b est fixé dans la borne de recharge B en un point, dit deuxième point, distinct dudit premier point.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif de compteur d'énergie électrique pour borne de recharge (B) en énergie électrique d'unités mobiles telles que des véhicules électriques, une telle borne de recharge (B) comprenant au moins un point de recharge (B1) permettant de distribuer de l'énergie électrique à une unité mobile connectée fonctionnellement audit point de recharge (B1), ledit dispositif comprenant au moins un compteur d'énergie électrique (1) apte et destiné à être fixé dans une telle borne de recharge (B) en étant dédié au ou à l'un de ses point(s) de recharge (B1) et à mesurer, avec une précision de mesure conforme, la quantité d'énergie électrique transmise par ledit point de recharge (B1) à l'unité mobile lors de sa recharge et au moins un élément d'affichage électronique (4), **caractérisé en ce qu'**il comprend en outre au moins un module (2) d'authentification des mesures comprenant un circuit électronique d'authentification (2a) configuré pour pouvoir contrôler l'authenticité desdites mesures, au moins une liaison de communication série (3) reliant fonctionnellement ledit module (2) d'authentification au ou à au moins l'un desdits compteur(s) d'énergie électrique (1) de sorte que ce dernier puisse transmettre les mesures audit module (2) d'authentification en vue de leur authentification et des moyens de fixation (2c) permettant de fixer le ou chaque module (2) d'authentification dans la borne de recharge (B) concernée.

2. Dispositif de compteur d'énergie électrique, selon la revendication 1, **caractérisé en ce que** le circuit électronique d'authentification (2) est configuré pour authentifier les mesures en les contrôlant de sorte à pouvoir les authentifier en signant les mesures authentifiées à l'aide de clés de sécurités mémorisées et en mémorisant lesdites mesures authentifiées et signées.

3. Dispositif de compteur d'énergie électrique, selon la revendication 1 ou 2, **caractérisé en ce que** le ou au moins l'un des module(s) (2) d'authentification comprend en outre le ou l'un des éléments d'affichage électronique (4) pour permettre l'affichage, au niveau du ou de chaque module (2) d'authentification concerné, d'informations provenant de son circuit électronique d'authentification (2a) et/ou du ou de l'un des compteur(s) d'énergie électrique (1) relié(s) audit module (2) d'authentification.

4. Dispositif de compteur d'énergie électrique, selon l'une quelconque des revendications 1 à 3, **caractérisé en ce que** le ou chaque compteur d'énergie électrique (1) comprend un boîtier (1a), dit premier boîtier, délimitant son espace interne et le ou chaque module (2) d'authentification comprend un boîtier (2b), dit deuxième boîtier, renfermant le ou l'un des circuits électronique d'authentification (2a) et **en ce que** le ou chaque premier boîtier (1a) est distinct du ou de chaque deuxième boîtier (2b).

5. Dispositif de compteur d'énergie électrique, selon l'une quelconque des revendications 1 à 4, caractérisé en ce en que la liaison de communication série (3) est une liaison de communication série (3) du type respectant la norme RS485 ou un protocole de communication Modbus.

6. Dispositif de compteur d'énergie électrique, selon l'une quelconque des revendications 1 à 4, caractérisé en ce en que la liaison de communication série (3) est une liaison de communication radiofréquence.

7. Dispositif de compteur d'énergie électrique, selon l'une quelconque des revendications 1 à 6, **caractérisé en ce qu'**il comprend, d'une part, au moins deux compteurs d'énergie électrique (1) aptes et destinés à être dédiés chacun à l'un des points de recharge (B1) d'une borne de recharge (B) comprenant au moins deux points de recharge (B1) et, d'autre part, au moins un module (2) d'authentification, le ou chaque module (2) d'authentification étant relié auxdits compteurs d'énergie électrique (1) ou à au moins deux desdits compteurs d'énergie électrique (1) par la ou au moins l'une des liaison de communication série (3).

8. Borne de recharge (B) en énergie électrique d'unités mobiles telles que des véhicules électriques, ladite borne de recharge (B) comprenant au moins un point de recharge (B1) permettant de distribuer de l'énergie électrique à une unité mobile connectée fonctionnellement audit point de recharge (B1), **caractérisée en ce qu'**elle comprend en outre un dispositif de compteur d'énergie électrique selon l'une quelconque des revendications 1 à 7 et **en ce que** le ou chaque compteur d'énergie électrique (1) et le ou chaque module (2) d'authentification dudit dispositif de compteur d'énergie électrique sont fixés dans l'espace interne de la borne de recharge (B).

9. Borne de recharge (B), selon la revendication 8, **caractérisée en ce qu'**elle comprend au moins deux points de recharge (B1), au moins deux compteurs d'énergie électrique (1) dédiés chacun à l'un desdits points de recharge (B1) et au moins un module (2) d'authentification, le ou chaque module (2) d'authentification étant relié auxdits compteurs d'énergie électrique (1) ou à au moins deux desdits compteurs d'énergie électrique (1).

10. Borne de recharge (B), selon l'une quelconque des revendications 8 à 9, **caractérisée en ce qu'**elle comprend au moins une ouverture ou fenêtre (B2) pratiquée à travers l'une de ses parois externes délimitant son espace interne et située en regard ou recevant l'élément d'affichage électronique (4) du ou de l'un des module (2) d'authentification de sorte à permettre à un utilisateur de voir ledit élément d'affichage électronique (4) depuis l'extérieur de la borne de recharge (B).

11. Borne de recharge (B), selon l'une quelconque des revendications 8 à 10 prises chacune en combinaison avec la revendication 4, **caractérisée en ce que** le ou chaque premier boîtier (1a) est fixé dans la borne de recharge (B) en un point, dit premier point et le ou chaque deuxième boîtier (2b) est fixé dans la borne de recharge (B) en un point, dit deuxième point, distinct dudit premier point.
